# EUROPEAN PATENT APPLICATION

(11) **EP 1 075 023 A1**
(43) Date of publication of application: **07.02.2001**
(21) Application number: 99916049.2
(22) Date of filing: 14.04.1999
(51) Int. Cl.: H01L 21/68

(54) **UNPROCESSED MATERIAL STORING DEVICE AND CARRY-IN/OUT STAGE**

(30) Priority: 16.04.1998 JP 12286298
(71) Applicant: Tokyo Electron Limited, Tokyo 107-8481 (JP)
(72) Inventor: MORIYA, Syuji, Kitakoma-gun Yamanashi 407-0204 (JP)
(74) Representative: Liesegang, Eva
(86) International application number: JP9901985
(87) International publication number: WO9954927

(57) **Abstract**

The present invention relates to a housing apparatus for housing therein an object to be processed, such as a semiconductor wafer, in a space filled with an inert gas when the object is transferred between various process systems. This housing apparatus has a door 46, which is airtightly open and closed, and comprises a container body 40 for housing therein a semiconductor wafer W. The container body 40 is provided with an intake port for introducing an inert gas, and an exhaust port for exhausting an inside atmosphere. On the distal end part of an intake nozzle which is connected to the intake port and which extends into the container body 40, a diffusion-force suppressing member 56 for suppressing a diffusion force of an introduced inert gas is provided, On the distal end part of an exhaust nozzle which is connected to the exhaust port and which extends into the container body 40, a convergent-force suppressing member 60 for suppressing a convergent force of an exhausted gas is provided.

## Description

### Technical Field

The present invention relates generally to a housing apparatus for housing therein an object to be processed, such as a semiconductor wafer, in a space filled with an inert gas when the object is transferred between various process systems, and a transfer stage for such a housing apparatus.

### Background Art

In order to produce a semiconductor integrated circuit or the like, it is required to repeat various processes, such as thin-film deposition, diffusion, exposure and etching processes, for a semiconductor wafer. Therefore, the wafer is generally transferred between different systems by an operator or an automatic transfer mechanism (e.g., AGV) in accordance with a processes to be executed.

In the circumstances, the wafer is not always transferred to the next process system immediately after the last process is completed, and the wafer is sometimes in a waiting state in a clean room for a long time until the next process is started. As is well known, a very fine patterning is carried out for a semiconductor wafer, so that the adhesion of particles is hated from the point of view of the improvement of yields. In addition, from the point of view of the improvement of electrical characteristics, it is required to avoid the forming of undesired films, such as natural oxide films, to the surface of the wafer.

When the design rule is not so severe, there are not so serious problems if the wafer stands by in the clean room as described above. However, scale down is recently making progress to make a demand for processes in submicrons, so that there are some undesired cases even in a clean room, in which the atmosphere of clean air is maintained, from the point of view of measures against particles and natural oxide films.

Therefore, a transportable container isolated from the outside atmosphere is prepared to house therein a plurality of, e.g., about 25, wafers, which are mounted in multistage, to be in a sealed state to transfer the wafers between process systems while being isolated from the outside atmosphere. This container is called, e.g., a cassette box. After a certain process is completed, processed wafers are housed in the cassette box to be sealed, and the operator transports the cassette box to the next process system.

By the way, the cassette box of this type can not avoid the slight forming of natural oxide films to the surface of the wafers since the atmosphere in the box is only isolated from the atmosphere of the outside clean room. Therefore, it is considered that an inert gas supply nozzle and an exhaust nozzle are provided in the box to fill the interior of the box with an inert gas, such as N₂ gas, to inhibit the adhesion of the particles as well as the production of natural oxide films as much as possible.

In this case, while the inert gas is supplied and sprayed from the inert gas supply nozzle, the atmosphere in the container body is exhausted from the exhaust nozzle to carry out gas exchange. At this time, it is not possible to avoid raising particles in the box due to the blowout of the gas. For that reason, although it is possible to inhibit the forming of natural oxide films, it is not possible to sufficiently inhibit the adhesion of particles.

Therefore, in order to avoid such a disadvantage, it is also considered that a filter serving to defuse the flow of an inert gas during the supply of the gas is provided as disclosed in Japanese Patent Laid-Open Nos. 2-184333 and 8-64582. However, although the techniques disclosed in these publications are related to load-lock chambers having a relatively excessive space, there is only a very small margin space in a cassette box. In addition, unlike load-lock chambers, the cassette box premises that it is carried. For that reason, the techniques disclosed in the above described publications can not be applied directly to means for supplying and exhausting the atmosphere in the cassette box.

The present invention has been made to effectively solve the above described problems, and it is an object of the present invention to provide a housing apparatus for housing therein an object to be processed, which is capable of inhibiting particles from being raised when the inside atmosphere is filled with an inert gas, and a transfer stage for such a housing apparatus.

### Disclosure of the Invention

In order to solve the above described problems, a housing apparatus for housing therein an object to be processed, according to the present invention, comprises: a container body for housing therein an object to be processed, the container body having a door which is airtightly open and closed; an intake port, provided in the container body, for introducing an inert gas; an exhaust port, provided in the container body, for exhausting an atmosphere in the container body; an intake nozzle which is connected to the intake port and which extends into the container body; and a diffusion-force suppressing member, provided on the distal end part of the intake nozzle, for suppressing a diffusion force of an introduced inert gas.

Thus, when an inert gas is supplied into the container body, the diffusion force of the inert gas is suppressed by the diffusion-force suppressing member provided on the intake nozzle, so that it is possible to inhibit particles from being raised by the diffusion force of the inert gas as much as possible. Therefore, it is possible to inhibit particles in the container body from adhering to the object, so that it is possible to improve the yields of the object.

The above described diffusion-force suppressing member may be made of a porous sintered body which is formed by sintering a ceramic or a metal fiber.

In addition, the intake nozzle may be provided with a plurality of gas injection holes, and the diffusion-force suppressing member may be provided so as to cover the gas injection holes.

Moreover, the diffusion-force suppressing member may comprise: a gas diffusion vessel which is connected to the intake nozzle and which extends substantially parallel to a plane of the object, the gas diffusion vessel having an open side; and a porous sintered body which is provided so as to cover the open side of the gas diffusion vessel and which is formed by sintering a ceramic or a metal fiber.

In addition, the housing apparatus may further comprise: an exhaust nozzle which is connected to the exhaust port and which extends into the container body; and a convergent-force suppressing member, provided on the distal end part of the exhaust nozzle, for suppressing a convergent force of an exhaust atmosphere.

Thus, when the inert gas is exhausted, the convergent force of the inert gas is suppressed by the convergent-force suppressing member provided on the exhaust nozzle, so that it is possible to inhibit particles from being raised by the convergent force of the inert gas. Therefore, it is possible to further inhibit the adhesion of the particles. The convergent-force suppressing member may be the same as the diffusion-force suppressing member.

Moreover, each of the intake port and the exhaust port may be provided with a shut-off valve which is open by a pressing force.

The present invention also provides a transfer stage for a housing apparatus for housing therein an object to be processed, the apparatus comprising, at least, a container body and an intake port and an exhaust port which are provided on the container body, the transfer stage supporting thereon the housing apparatus for transferring the object between the housing apparatus and a process system.

This transfer stage comprises: a supporting table for supporting thereon the housing apparatus; gas supply means, provided on the supporting table and detachably connected to an intake port of the housing apparatus, for supplying an inert gas into the container body; and exhaust means, provided on the supporting table and detachably connected to an exhaust port of the housing apparatus, for exhausting an atmosphere in the container body.

Thus, by setting the housing apparatus on the supporting table of the transfer stage to connect the gas supply means and exhaust means of the transfer stage to the intake port and exhaust port of the housing apparatus, respectively, it is possible to replace the atmosphere in the container body of the housing apparatus with an inert gas.

In addition, the present invention provides a transfer stage for a housing apparatus for housing therein an object to be processed, the apparatus comprising , at least, a container body and an intake port and an exhaust port which are provided on the container body, each of the intake port and the exhaust port being provided with a shut-off valve which is open by a pressing force, the transfer stage supporting thereon the housing apparatus for transferring the object between the housing apparatus and a process system.

This transfer stage comprises: a supporting table for supporting thereon the housing apparatus; gas supply means, provided on the supporting table and detachably connected to an intake port of the housing apparatus, for supplying an inert gas into the container body; and exhaust means, provided on the supporting table and detachably connected to an exhaust port of the housing apparatus, for exhausting an atmosphere in the container body, the gas supply means having an intake connection nozzle which protrudes from the supporting table so as to correspond to the intake port of the housing apparatus, and the exhaust means having an exhaust connection nozzle which protrudes from the supporting table so as to correspond to the exhaust port of the housing apparatus.

Thus, if the housing apparatus is set on the supporting table of the transfer stage, the intake port and exhaust port of the housing apparatus can be connected to the intake connection nozzle and exhaust connection nozzle of the transfer stage, respectively. At this time, the shut-off valves of the intake port and exhaust port of the housing apparatus can be pressed by the intake connection nozzle and exhaust connection nozzle of the transfer stage to be open. Therefore, only by setting the housing apparatus on the supporting table of the transfer stage, the intake port and exhaust port of the housing apparatus can be automatically communicated with the gas supply means and exhaust means of the transfer stage, so that the atmosphere in the housing apparatus can be replaced with the inert gas.

### Brief Description of the Drawings

FIG. 1 is a perspective view showing a housing apparatus according to the present invention;
FIG. 2 is a cross-sectional view of the housing apparatus shown in FIG. 1;
FIG. 3 is a partially sectional side view showing a container body of the housing apparatus shown in FIG. 1;
FIG. 4 is a partially enlarged sectional view of the container body shown in FIG. 3;
FIG. 5 is an illustration showing a state that a housing apparatus according to the present invention is set on a transfer stage;
FIG. 6 is a schematic perspective view showing a transfer stage;
FIG. 7 is a partially enlarged sectional view showing a state immediately before a gas port of a housing apparatus is connected;
FIG. 8 is a partially enlarged sectional view showing a state that a gas port of a housing apparatus is connected;
FIG. 9 is a perspective view showing a modified example of a diffusion-force suppressing member;
FIG. 10 is a sectional view of the suppressing member shown in FIG. 8;
FIGS. 11A through 11C are schematic block diagrams showing an evaluation system for evaluating the present invention; and
FIG. 12 is a graph for explaining the evaluated results of the present invention.

### Best Mode for Carrying Out the Invention

Referring to the accompanying drawings, a preferred embodiment of a housing apparatus for housing therein an object to be processed, and a transfer stage according to the present invention will be described below.

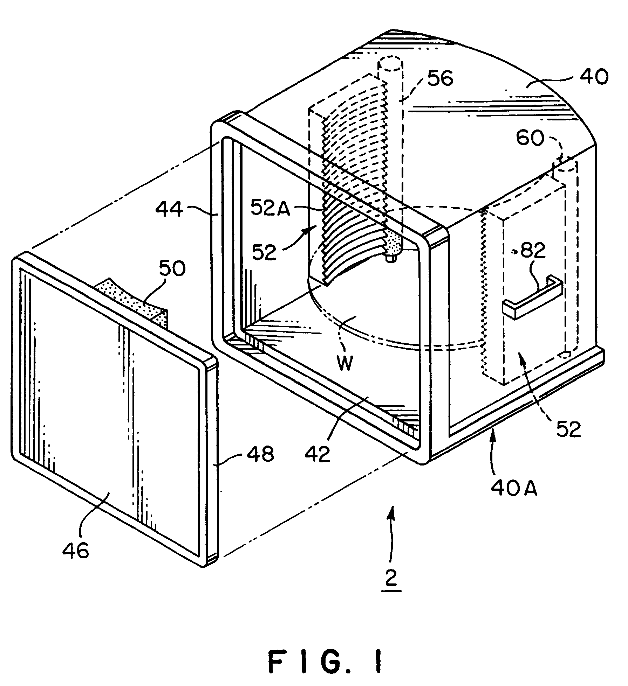

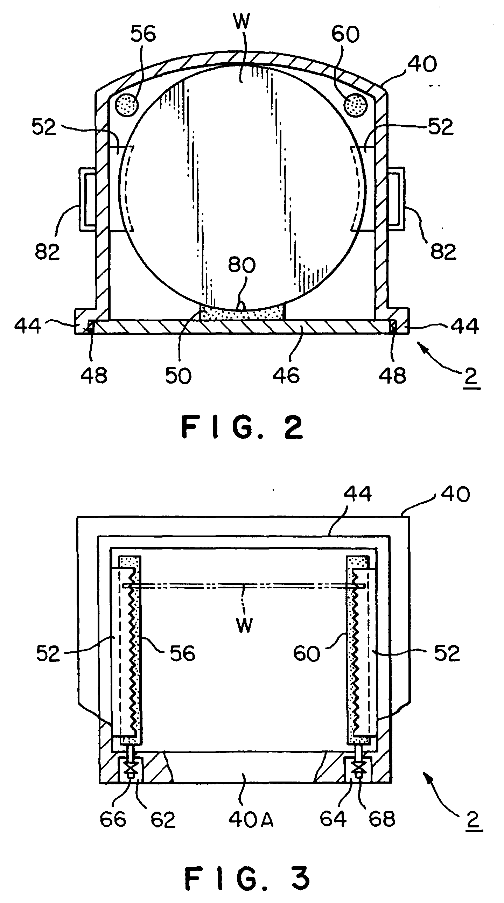

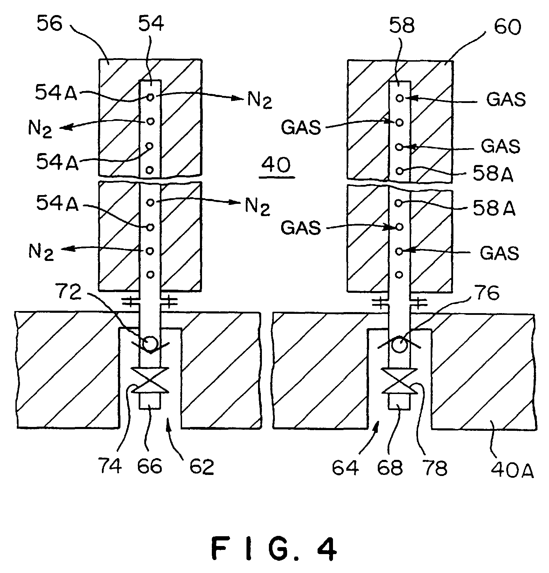

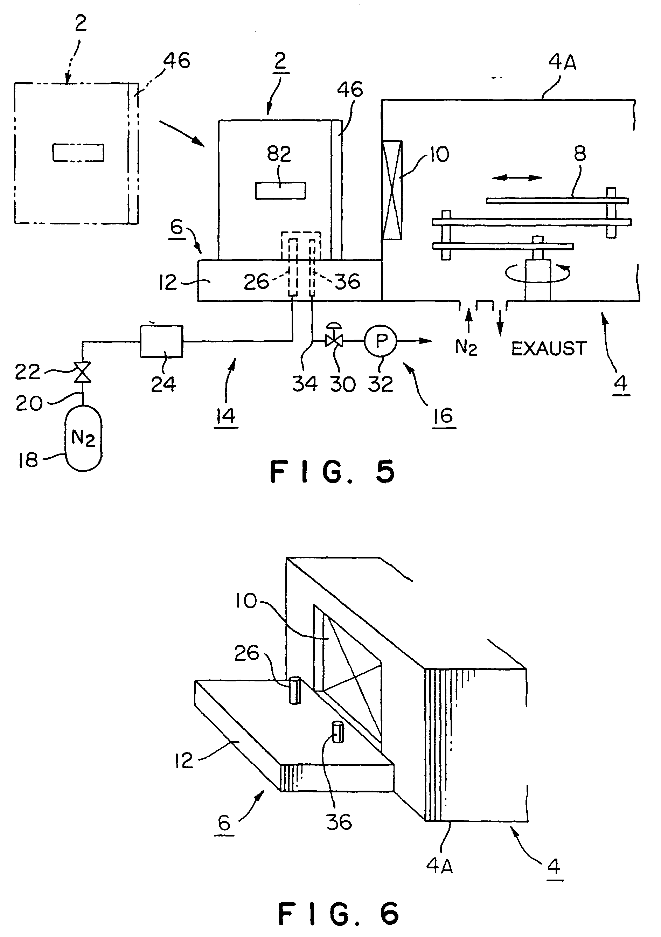

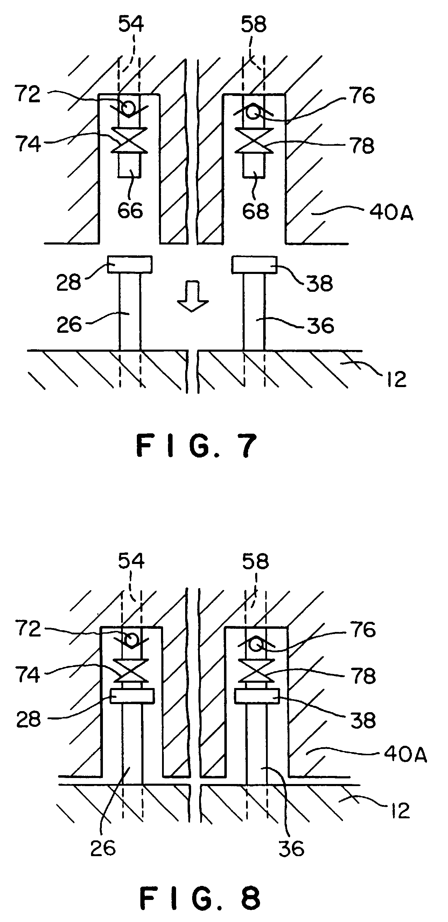

FIG. 1 is a perspective view showing a housing apparatus according to the present invention, FIG. 2 is a cross-sectional view of the housing apparatus shown in FIG. 1, FIG. 3 is a partially sectional side view showing a container body of the housing apparatus shown in FIG. 1, FIG. 4 is a partially enlarged sectional view of the container body shown in FIG. 3, FIG. 5 is an illustration showing a state that a housing apparatus according to the present invention is set on a transfer stage, FIG. 6 is a schematic perspective view showing a transfer stage, FIG. 7 is a partially enlarged sectional view showing a state immediately before a gas port of a housing apparatus is connected, and FIG. 8 is a partially enlarged sectional view showing a state that a gas port of a housing apparatus is connected.

First, the relationship between a housing apparatus and a transfer stage according to the present invention will be described. As shown in FIG. 1, a housing apparatus 2 is designed to house therein objects to be processed, such as semiconductor wafers, in multistage to isolate the objects from the outside atmosphere, and has a size so as to be capable of being carried by an operator or an automatic transfer system (e.g., AGV). In addition, as shown in FIG. 5, a transfer stage 6 is provided on the side of an inlet of a process system 4 for carrying out a predetermined process for the semiconductor wafers. The housing apparatus 2 is set on the transfer stage 6, then the wafers are introduced into the process system 4.

The process system 4 comprises: a process chamber for actually carrying out a process, such as a heat treatment, for the wafers; and a transfer chamber, such as a load-lock chamber, which is connected to the front part of the process chamber and which is capable of being evacuated. In FIG. 5, a load-lock chamber 4A serving as a transfer chamber is shown. In the load-lock chamber 4A, there is provided an multi-articulated transfer arm 8 which is capable of bending, stretching, swiveling and vertically moving to transfer the wafers. On the side wall of the load-lock chamber 4A facing on the transfer stage 6, an airtightly opening and closing gate door 10 is provided (see FIG. 6). In addition, an inert gas, e.g., N₂ gas, is capable of being purged into the load-lock chamber 4A.

As shown in FIGS. 5 and 6, the transfer stage 6 has a supporting table 12 which extends from the load-lock chamber 4A on the side of the gate door 10. On the supporting table 12, the housing apparatus 2 is set. The supporting table 12 is provided with gas supply means 14 for supplying N₂ gas or the like serving as the inert gas into the housing apparatus 2, and exhaust means 16 for exhausting atmosphere in the housing apparatus 2 while regulating pressure.

Specifically, the gas supply means 14 has a gas supply passage 20, one end of which is connected to an N₂ gas source 18 for storing N₂ gas therein. In the gas supply passage 20, a shut-off valve 22 and a flow controller 24 are provided. The other end of the gas supply passage 20 is connected to an intake connection nozzle 26 which is provided in the supporting table 12 so as to protrude by a predetermined height. The distal end of the intake connection nozzle 26 is provided with an automatic joint 28 (see FIG. 7) which is connected to an intake port 66 of the housing apparatus by the snapping force when being pressed to the port 66.

The exhaust means 16 has an exhaust passage 34 in which a pressure regulating valve and an exhaust pump 32 are provided. Similar to the above described intake connection nozzle 26, the proximal end of the exhaust passage 34 is connected to an exhaust connection nozzle 36 which is provided in the supporting table 12 so as to protrude by a predetermined height. The distal end of the exhaust connection nozzle 36 is also provided with an automatic joint 38 (see FIG. 7) which is connected to an exhaust port 58 of the housing apparatus 2 by the snapping force when being pressed to the port 58.

Referring to FIGS. 1 through 4, the housing apparatus 2 will be described below. As shown in FIG. 1, the housing apparatus 2 has a substantially rectangular parallelepiped container body 40, one side of which is open to serve as a transfer port 42. The container body 40 is made of, e.g., a transparent polycarbonate resin, so that its interior can be visually recognized. The container body 40 is provided with an outward protruding flange portion 44 around the transfer port 42. A substantially rectangular door 46 is detachably inserted into the flange-portion 44.

A seal member 48 of, e.g., polyurethane, is provided on the whole periphery of the door 46 so that the interior of the container body 40 can be in an airtight state when the door 46 is inserted. At the center of the internal surface of the door 46, an elastic presser member 50 of, e.g., an elastic fluorine containing resin, is provided so as to extend in vertical directions. The elastic presser member 50 serves to press wafers, which are housed in the container body 40, so as to prevent the wafers from moving in horizontal directions.

As shown in FIGS. 1 through 3, a pair of supporting members 52 for supporting a plurality of semiconductor wafers W in multistage are provided on the internal surfaces of the container body 40 which are perpendicular to directions in which the wafers are transferred. Specifically, the supporting members 52 are made of, e.g., a fluorine containing resin which is difficult to produce particles, and comprises arc-shaped supporting grooves 52A which are formed in multistage at regular intervals. The supporting members 52 are designed to hold the semiconductor wafers W by supporting part of the peripheral portions of the wafers W in the supporting grooves 52A. The number of wafers W capable of being housed can be optionally set, and is generally about 13 through 25.

In the inner part of the container body 40, a diffusion-force suppressing member 56 and a convergent-force suppressing member 60, which are features of the present invention, are provided. Specifically, as shown in FIGS. 3 and 4, two recessed portions 62 and 64 are provided in the bottom portion 40A of the container body 40 so as to be open downward. An intake port 66 and an exhaust port 68, which pass through the bottom portion 40A, are provided in the recessed portion 62 and 64, respectively. As shown in FIG. 4, the intake port 66 is connected to an intake nozzle 54 which vertically extends from one corner of the container body 40, and the exhaust port 68 is connected to an exhaust nozzle 58 which vertically extends from the other corner of the container body 40. The nozzles 54 and 58 are provided with a large number of gas injection holes 54A and a large number of gas suction holes 58A, respectively, which are spaced from each other in longitudinal directions.

The elongated cylindrical diffusion-force suppressing member 56 is provided on the whole intake nozzle 54 so as to cover the gas injection holes 54A. The diffusion-force suppressing member 56 is made of a porous ceramic sintered body which is formed by sintering powder, such as alumina, or a porous metal sintered body which is formed by sintering fibers of a metal, such as stainless or nickel, so as to weaken and suppress the diffusion force of a gas which is discharged from the gas injection holes 54A.

The elongated cylindrical convergent-force suppressing member 60 is provided on the whole exhaust nozzle 58 so as to cover the gas suction holes 58A. The material and structure of the convergent-force suppressing member 60 are the same as those of the diffusion-force suppressing member 56 so as to relieve or suppress the convergent force of a gas converging herein to prevent any turbulent flows.

The intake port 66 is provided with a check valve 72 which is open when a gas flows toward the container body 40, and a shut-off valve 74 which is open when a predetermined pressing force is applied. In addition, the exhaust port 68 is provided with a check valve 76 which is open when a gas flows outward from the container body 40, and a shut-off valve 78 which is open when a predetermined pressing force is applied. These shut-off valves 74 and 78 may be, e.g., coupler type shut-off valves.

Each of the wafers W housed in the housing apparatus 2 has a size of, e.g., 12 inches (30 cm), and is formed with a notch 80 (see FIG. 2) for indicating its direction. When the housing apparatus 2 houses therein the wafers W having a size of 12 inches, the length and width of the container body 40 are set to be about 350 mm. In addition, when the housing apparatus 2 houses therein 13 wafers, the height of the container body 40 is set to be about 200 mm, and when the housing apparatus 2 houses therein 25 wafers, the height of the container body 40 is set to be about 400 mm.

A pair of handles 82 are mounted on the side walls of the container body 40 so as to easily carry the housing apparatus 2. The door 46 is provided with a lock mechanism (not shown). By releasing this lock mechanism manually or by an automatic mechanism, the door 46 can be removed.

With the above described construction, the operations of the housing apparatus and transfer stage will be described below. First, a plurality of, e.g., 25, wafers W, for which a predetermined process is carried out at the last step, are housed in the housing apparatus 2 in the sealed stage as shown in FIG. 2. The interior of the container body 40 of the housing apparatus 2 is filled with N₂ gas serving as an inert gas at a pressure of about one atm in a process system or the like in which the last step has been carried out.

The housing apparatus 2 in such a state is transferred by an operator or an automatic transfer mechanism (e.g., AGV) , in a clean room, to be set on the supporting table 12 of the transfer stage 6 at a predetermined position while the door 46 faces the process system 4 as shown in FIG. 5. At this time, as extensively shown in FIGS. 7 and 8, the intake connection nozzle 26 and exhaust connection nozzle 36 on the supporting table 12 engage the intake port 66 and exhaust port 68 provided in the bottom portion 40A of the container body 40, respectively, to be connected thereto by means of the automatic joints 28 and 38. By these connections, the shut-off valves 74 and 78 of each of the ports 66 and 68 are open so as to allow the supply of N₂ gas into the container body 40 and the exhaust from the container body 40.

In such a state, if the locking of the door 46 of the housing apparatus 2 is released by an automatic mechanism (not shown) to remove the door 46, the container body 40 is open. At this time, the gate door 10 of the load-lock chamber 4A shown in FIG. 5 is open. Then, if the transfer arm 8 in the load-lock chamber 4A swivels and/or bends and stretches, the semiconductor wafers W housed in the container body 40 are held and sequentially fed into the load-lock chamber 4A. Then, after a predetermined process is carried out for the semiconductor wafers W in a process chamber (not shown) of the process system 4, the opposite transfer operation to the above described transfer operation is carried out to return the processed wafers W into the container body 40 of the housing apparatus 2 again. If all of the wafers W are returned into the container body 40, the door 46 is closed so that the container body 40 is in the sealed state again.

In this state, although the interior of the container body 40 is filled with clean air in the clean room, it is required to replace the atmosphere in the container body with inert N₂ gas, otherwise natural oxide films may be produced on the surface of the wafer w. Therefore, N₂ gas rate-controlled by the rate controller 24 is caused to flow from the N₂ gas source 18 of the gas supply means 14 shown in FIG. 5, to be supplied from the intake nozzle 54 into the container body 40 via the intake port 66 little by little as shown in FIG. 4. Simultaneously with this operation for supplying N₂ gas, the exhaust pump 32 of the exhaust means 16 is also driven to exhaust atmosphere in the container body 40 from the exhaust nozzle 58 via the exhaust port 68 at a rate corresponding to the supply of N₂ gas as shown in FIG. 4. Thus, the atmosphere in the container body 40 is replaced with N₂ gas to prevent natural oxide films from being produced on the surface of the wafer w.

When N₂ gas is introduced, if the pressure of N₂ gas supplied from the intake nozzle 54 is suddenly released, there is a problem in that the gas flow is disturbed by the diffusion force to raise particles, which have been settled in the container body 40, so that the raised particles adhere to the surface of the wafer W. Therefore, in this preferred embodiment, the intake nozzle 54 is provided with the large number of gas injection holes 54A, and the diffusion-force suppressing member 56 of the porous sintered body is provided so as to cover the gas injection holes 54A. Thus, the diffusion force of the introduced N₂ gas is suppressed by the diffusion-force suppressing member 56, so that the introduced N₂ gas gradually flows into the container body 40 without being suddenly diffused. Therefore, it is possible to prevent the disadvantage in that particles in the container body 40 are raised to adhere the wafer w.

Also with respect to the exhaust nozzle 58, there is the possibility that a turbulent flow is produced in the atmosphere in the container body 40, which is sucked into the exhaust nozzle 58, to raise particles. Therefore, the exhaust nozzle 58 is also provided with the large number of gas suction holes 58A, and the convergent-force suppressing member 60 having the same material and structure as those of the diffusion-force suppressing member 56 is provided so as to cover the gas suction holes 58A. Thus, the convergent force of the exhausted atmospheric gas is suppressed by the convergent-force suppressing member 60, so that the exhausted atmospheric gas is gradually introduced into the exhaust nozzle 58 from the gas suction holes 58A to be exhausted without being suddenly converged. Therefore, also in this case, no turbulent flow is produced, so that there is no problem in that particles in the container body 40 are raised to adhere to the wafer w and so forth.

In addition, since the diffusion-force suppressing member 56 and the convergent-force suppressing member 60 are arranged in empty spaces at the corners in the inside of the container body 40 as shown in FIG. 2, it is hardly required to increase the volume of the container body 40 itself in order to provide the suppressing members 56 and 60. Thus, by providing the suppressing members 56 and 60 on both of the intake and exhaust portions, it is possible to greatly inhibit particles in the container body 40 from being raised.

In addition, the above described connection of the intake port 66 to the gas supply means 14, and the above described connection of the exhaust port 68 to the exhaust means 16 can be automatically carried out only by setting the housing apparatus 2 on the supporting table 12 of the transfer stage 6 at a predetermined position. In addition, each disconnection can be carried out only by lifting the housing apparatus 2 from the supporting table 12. While N₂ gas has been used as the inert gas, Ar gas, He gas or the like may be used.

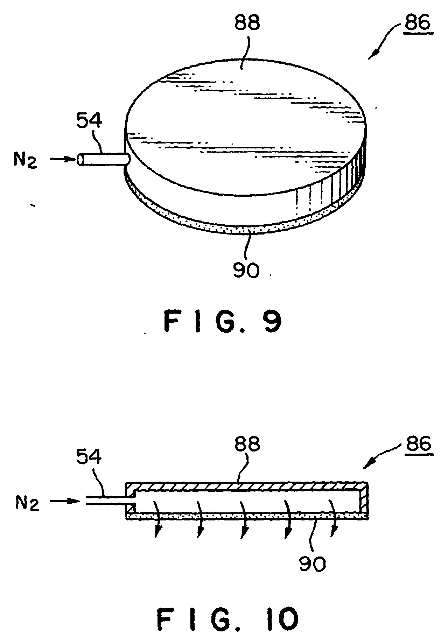

While the elongated cylindrical porous sintered body has been used as the diffusion-force suppressing member 56, a disk-shaped diffusion-force suppressing member 86 shown in FIGS. 9 and 10 may be used. This diffusion-force suppressing member 86 is provided on, e.g., the ceiling surface of the container body 40, and has a thin gas-diffusion vessel 88 having substantially the same area as that of the wafer W. One side face, e.g., the bottom face, of the gas diffusion vessel 88 is open to be covered with a porous sintered body 90 of the same material as that of the above described diffusion-force suppressing member 56. The gas diffusion vessel 88 is made of, e.g., stainless, and the side portion thereof is provided with the intake nozzle 54 for introducing N₂ gas.

Also in this case, N₂ gas introduced into the gas diffusion vessel 88 is supplied into the container body 40 while its diffusion force is suppressed by the porous sintered body 90, so that it is possible to prevent particles in the container body 40 from being raised similar to the above described preferred embodiment. In addition, of course, the disk-shaped diffusion-force suppressing member 86 can be similarly applied as the convergent-force suppressing member.

When the housing container was provided with various diffusion-force suppressing members and when the housing container was provided with no diffusion-force suppressing members, the state of the adhesion of the particles were actually evaluated. The evaluated results will be described below.

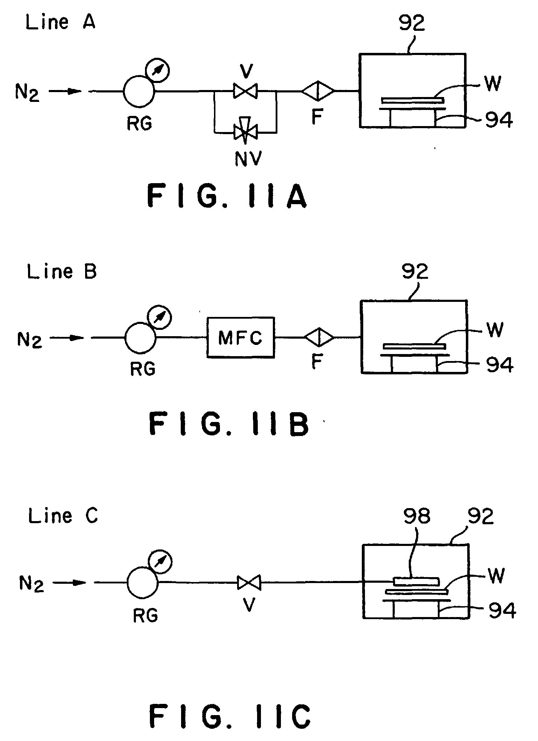

FIG. 11 is a schematic block diagram showing an evaluating system, wherein FIGS. 11A and 11B show cases where no diffusion-force suppressing member is provided, and FIG. 11C shows a case where the diffusion-force suppressing member 98 is provided. In the figures, reference number 92 denotes a vacuum vessel in which a wafer W is supported on a susceptor 94. RG denotes a regulator, F denotes a filter, V denotes a valve, NV denotes a needle valve, and MFC denotes a flow control valve.

In the case of line A shown in FIG. 11A, N₂ gas is supplied via the needle valve NV until the pressure in the vacuum vessel 92 becomes 10 Torr, and thereafter, the valve V is open to supply N₂ gas at a stretch until the pressure becomes 1 atm. In the case of line B shown in FIG. 11B, the flow control valve MFC is controlled to linearly increase the flow rate of N₂ gas with the elapse of time. The case of line C shown in FIG. 11C corresponds to the present invention. In this case, the valve V is open to supply N₂ gas at a stretch, and its diffusion force is suppressed by the diffusion-force suppressing member 98.

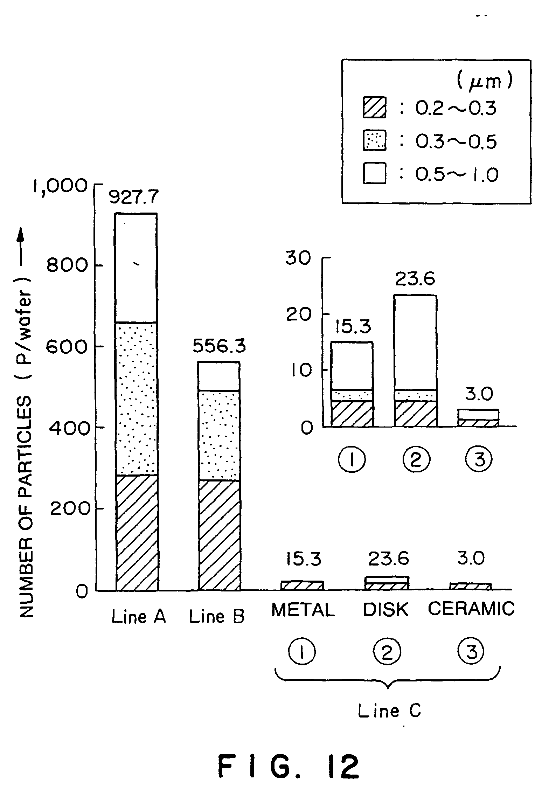

As the diffusion-force suppressing member, there were prepared three kinds of members, i.e., a cylindrical suppressing member formed by sintering metal fibers, a disk-shaped suppressing member shown in FIGS. 9 and 10, and a cylindrical suppressing member formed by sintering ceramic powder. Then, N₂ gas was purged into the vacuum vessel 92, and particles adhering to the surface of the wafer W at that time were measured every size. The evaluated results are shown in FIG. 12. On the right-upper side in FIG. 12, an enlarged graph of the evaluated results according to the present invention is shown.

As can be clearly seen from FIG. 12, in the cases of lines A and B wherein no suppressing member is used, a large quantity of particles having every size are raised to adhere to the surface of the wafer. On the other hand, in the case of line C, it is revealed that the number of particles is very small, and particularly, in the case of the suppressing member of the ceramic sintered body, the number of particles is minimum, which shows good results. Furthermore, evaluation was herein carried out under severe conditions that N₂ gas was purged into the vacuum vessel. However, when the atmosphere in the housing apparatus at a pressure of about 1 atm is replaced with N₂ gas, the diffusion force of the gas is smaller than that when the gas is purged into the vacuum vessel, so that the greater decrease of the number of particles than the above described results of the experiment can be expected.

While the exhaust nozzle 58 and the convergent-force suppressing member 60 have been provided on the exhaust portion of the housing container 2 in the above described preferred embodiment, the exhaust nozzle 58 and the convergent-force suppressing member 60 may be omitted, and only the exhaust port 68 may be provided.

In addition, while the wafer has had the size of 12 inches (30 cm) in the above described preferred embodiment, the present invention may be applied to a wafer having a size of 6 inches (15 cm) or 8 inches (20 cm). Moreover, the object to be processed should not be limited to the semiconductor wafer, but it may be a glass substrate or an LCD substrate.

## Claims

1. A housing apparatus for housing therein an object to be processed, said housing apparatus comprising:
a container body for housing therein an object to be processed, said container body having a door which is airtightly open and closed;
an intake port, provided in said container body, for introducing an inert gas;
an exhaust port, provided in said container body, for exhausting an atmosphere in said container body;
an intake nozzle which is connected to said intake port and which extends into said container body; and
a diffusion-force suppressing member, provided on the distal end part of said intake nozzle, for suppressing a diffusion force of an introduced inert gas.

2. A housing apparatus for housing therein an object to be processed, as set forth in claim 1, wherein said diffusion-force suppressing member is made of a porous sintered body which is formed by sintering a ceramic or a metal fiber.

3. A housing apparatus for housing therein an object to be processed, as set forth in claim 1 or 2, wherein said intake nozzle is provided with a plurality of gas injection holes, and said diffusion-force suppressing member is provided so as to cover said gas injection holes.

4. A housing apparatus for housing therein an object to be processed, as set forth in claim 1, wherein said diffusion-force suppressing member comprises:
a gas diffusion vessel which is connected to said intake nozzle and which extends substantially parallel to a plane of said object, said gas diffusion vessel having an open side; and
a porous sintered body which is provided so as to cover said open side of said gas diffusion vessel and which is formed by sintering a ceramic or a metal fiber.

5. A housing apparatus for housing therein an object to be processed, as set forth in any one of claims 1 through 4, which further comprises:
an exhaust nozzle which is connected to said exhaust port and which extends into said container body; and
a convergent-force suppressing member, provided on the distal end part of said exhaust nozzle, for suppressing a convergent force of an exhaust atmosphere.

6. A housing apparatus for housing therein an object to be processed, as set forth in any one of claims 1 through 5, wherein each of said intake port and said exhaust port is provided with a shut-off valve which is open by a pressing force.

7. A transfer stage for a housing apparatus for housing therein an object to be processed, said apparatus comprising , at least, a container body and an intake port and an exhaust port which are provided on said container body, said transfer stage supporting thereon said housing apparatus for transferring said object between said housing apparatus and a process system, said transfer stage comprising:
a supporting table for supporting thereon said housing apparatus;
gas supply means, provided on said supporting table and detachably connected to an intake port of said housing apparatus, for supplying an inert gas into said container body; and
exhaust means, provided on said supporting table and detachably connected to an exhaust port of said housing apparatus, for exhausting an atmosphere in said container body.

8. A transfer stage for a housing apparatus for housing therein an object to be processed, said apparatus comprising, at least, a container body and an intake port and an exhaust port which are provided on said container body, each of said intake port and said exhaust port being provided with a shut-off valve which is open by a pressing force, said transfer stage supporting thereon said housing apparatus for transferring said object between said housing apparatus and a process system, said transfer stage comprising:
a supporting table for supporting thereon said housing apparatus;
gas supply means, provided on said supporting table and detachably connected to an intake port of said housing apparatus, for supplying an inert gas into said container body; and
exhaust means, provided on said supporting table and detachably connected to an exhaust port of said housing apparatus, for exhausting an atmosphere in said container body,
said gas supply means having an intake connection nozzle which protrudes from said supporting table so as to correspond to said intake port of said housing apparatus, and
said exhaust means having an exhaust connection nozzle which protrudes from said supporting table so as to correspond to said exhaust port of said housing apparatus.
